# EUROPÄISCHE PATENTANMELDUNG

(11) **EP 4 518 590 A1**
(43) Veröffentlichungstag der Anmeldung: **05.03.2025**
(21) Anmeldenummer: 24192201.2
(22) Anmeldetag: 31.07.2024
(51) Int. Cl.: H05K 1/18, H05K 3/28, H05K 1/02

(54) **ISOLIERUNG VON BAUTEILEN AUF EINER LEITERPLATTE**

(30) Priorität: 22.08.2023 DE 102023122411
(71) Anmelder: Lisa Dräxlmaier GmbH, 84137 Vilsbiburg (DE)
(72) Erfinder: Murgott, Krzysztof, 85716 Unterschleißheim (DE); Schafferhans, Stephan, 81477 München (DE); Hagenauer, Stefan, 84051 Altheim (DE)

(57) **Zusammenfassung**

Vorgeschlagen wird eine Vorrichtung zur Isolierung eines elektronischen Bauteils, aufweisend: eine Leiterplatte, ein elektronisches Bauteil angeordnet auf einer Oberfläche der Leiterplatte, ein versteifendes Element, welches konfiguriert und angeordnet ist das elektronische Bauteil zumindest teilweise zu umgeben, wobei das versteifende Element an der Oberfläche der Leiterplatte angeordnet ist, und wobei das versteifende Element konfiguriert und angeordnet ist das elektronische Bauteil von einer Umgebung zu isolieren.

## Beschreibung

### Technisches Gebiet

Die vorliegende Erfindung betrifft eine Vorrichtung zur Isolierung eines elektronischen Bauteils auf einer Leiterplatte. Zudem betrifft die Erfindung ein Verfahren zum Herstellen einer Isolierung eines elektronischen Bauteils auf einer Leiterplatte und eine Verwendung der Vorrichtung in einem elektrisch betriebenen Fahrzeug.

### Stand der Technik

Zum Einhalten bestimmter Funktionen von Bauteilen, welche auf einer Platine befestigt sind, beispielsweise aufgelötet sind, müssen diese Bauteile durch die Anwendung von Isolationsmaterial gegenüber der Umgebung elektrisch isoliert werden. Das Isolationsmaterial kann dabei ein aushärtendes Material sein. Eben dieses Isolationsmaterial kann bei dessen Applikation verlaufen und dadurch unbeabsichtigte Flächen vernetzten und isolieren. Durch dieses unbeabsichtigte Verlaufen werden Prozessunsicherheiten erzeugt, zum Beispiel müssen dadurch Bauteile mit entsprechend großen Abstandstoleranzen auf der Platine platziert werden. D.h.es muss beachtet werden, bis zu welchem Abstand das Isolationsmaterial von dem zu isolierenden Bauteil verläuft. Weiterhin können unterschiedliche Schichtdicken des Isolationsmaterials an dem Bauteil und der Platine auftreten, welche unter Umständen zu einer geringeren Isolationsfestigkeit führen. Ferner kann es bei der Verwendung von dickflüssigem Isolationsmaterial zur Blasenneigung im Isolationsmaterial selbst kommen. Durch Blasen im Isolationsmaterial kann es zu Teilentladungen kommen und dadurch das Isolationsmaterial über der Lebenszeit des Bauteils versagen. Durch die entsprechende Applikation des Isolationsmaterials dürfen einige der elektronischen Bauteile nicht direkt aufgedrückt werden, obwohl dies für einen optimalen Wärmefluss zwischen Bauteil und Platine notwendig wäre.

Es bestehen verschiedene Möglichkeiten dem entgegenzuwirken, wie das Generieren von Barrieren für das Isolationsmaterial, oder Einsetzen von gedruckten Bauteilen, Einbetten von Sensoren in die Platine oder das Verwenden von vorgeformten isolierenden Platinen bzw. Folien. Bei diesen verschiedenen Möglichkeiten sind zumeist zusätzliche Prozesse und weiteres Material notwendig was den Arbeitsaufwand und die Arbeitszeit merklich erhöht. Darüber hinaus besteht das Problem das diese Möglichkeiten häufig geringere Messgenauigkeiten des elektronischen Bauteils verursachen und auch erhöhte Toleranzen bei der Bauteilpositionierung erzeugen. Hierfür müssen im Stand der Technik häufig zusätzliche aufwendige Fertigungs- und/oder Prozessschritte vorgesehen werden und/oder geringerer Messgenauigkeiten akzeptiert werden.

Es besteht daher der Bedarf nach einer verbesserten Vorrichtung zum Isolieren von einem und/oder mehreren Bauteilen auf einer Leiterplatte, welches eine genauere Platzierung von Bauteilen auf der Leiterplatte und eine verbesserte Isolationseigenschaft liefern kann.

### Beschreibung der Erfindung

Eine Aufgabe der Erfindung ist es daher, unter Einsatz konstruktiv möglichst einfacher Mittel eine verbesserte Isolation eines elektronischen Bauteils auf einer Leiterplatte bereitzustellen, wodurch zumindest teilweise die oben angeführten Probleme gelöst werden.

Die Aufgabe wird durch die Gegenstände der unabhängigen Ansprüche gelöst. Vorteilhafte Weiterbildungen der Erfindung sind in den abhängigen Ansprüchen, der Beschreibung und den begleitenden Figuren angegeben.

Die beschriebenen Ausführungsformen gelten gleichermaßen für das Verfahren zum Herstellen einer Isolierung eines elektronischen Bauteils auf einer Leiterplatte (bzw. Platine), sowie die Vorrichtung zur Isolierung eines elektronischen Bauteils auf einer Platine und für die Verwendung der Vorrichtung. Synergetische Effekte können aus verschiedenen Kombinationen der Ausführungsformen entstehen, auch wenn sie nicht im Detail beschrieben sind.

Gemäß einem Aspekt der Erfindung wird eine Vorrichtung zur Isolierung eines elektronischen Bauteils bereitgestellt, welche aufweist eine Leiterplatte, ein elektronisches Bauteil angeordnet auf einer Oberfläche der Leiterplatte, ein versteifendes Element, welches konfiguriert und angeordnet ist das elektronische Bauteil zumindest teilweise zu umgeben, wobei das versteifende Element an der Oberfläche der Leiterplatte angeordnet ist, wobei das versteifende Element konfiguriert und angeordnet ist das elektronische Bauteil von einer Umgebung zu isolieren.

In anderen Worten weist die Vorrichtung eine Leiterplatte, ein elektronisches Bauteil angeordnet auf der Leiterplatte, ein versteifendes Element auf, welches das elektronische Bauteil teilweise umgibt, und wobei das versteifende Element als Isolator/Isolierung fungiert, welches das elektronische Bauteil teilweise isoliert. Dabei sind das elektronische Bauteil und das versteifende Element auf einer Oberfläche der Leiterplatte angeordnet, wobei beide Elemente auf derselben Oberfläche der Leiterplatte angeordnet sind, d.h. auf der selben Fläche der Leiterplatte. Das versteifende Element umgibt das elektronische Bauteil zumindest teilweise, wobei von dem elektronischen Bauteil zumindest eine oder mehrere Seiten umgeben werden können. Beispielsweise ist eine unterste Oberfläche des elektronischen Bauteils in Richtung der Leiterplatte offen, damit ein Kontakt mit der Leiterplatte hergestellt werden kann. Ferner kann das versteifende Element zu einer oder mehrere Seiten um das elektronische Bauteil offen sein, sodass diese Seiten frei zugänglich sind. Ein vollständiges Umgeben des elektronischen Bauteils ist jedoch davon nicht ausgenommen. Weitere möglichen Ausführungsformen werden in den nachfolgenden Ausführungsbeispielen erläutert.

Unter einer Isolierung des elektronischen Bauteils von einer Umgebung, kann unter anderem verstanden werden, dass das elektronische Bauteil von anderen elektronischen Komponenten welche auf oder in der Nähe der Leiterplatte angeordnet sind bzw. sich dort befinden isoliert wird. Ferner kann darunter auch verstanden werden, dass das elektronische Bauteil von anderen elektronischen Potenzialen, welche von anderen elektronischen Bauteilen erzeugt werden, zum Beispiel einem Leiterstrang in einem Elektroauto, isoliert wird. Die Umgebung des elektronischen Bauteils ist insbesondere eine Umgebung der Leiterplatte, welche elektronischen oder magnetischen Einflüssen von anderen Bauteilen ausgesetzt wird und somit das elektronische Bauteil beeinflussen würde. Von eben diesen Einflüssen soll das elektronische Bauteil mittels der erfindungsgemäßen Isolation geschützt werden und deren Einflüsse auf das elektronische Bauteil verringert werden, sodass sich Beispielsweise eine höhere Messgenauigkeit des elektronischen Bauteils bereitgestellt werden kann.

Durch die erfindungsgemäße Vorrichtung kann so, mit einfachen konstruktiven Mitteln eine Isolation des elektronischen Bauteils bereitgestellt werden. Dies führt dazu, dass Toleranzen zu Bauteilgrenzen einfacher eingehalten werden können und somit für die Konstruktion und Anbringung von elektronischen Bauteilen bessere, d.h. zum Beispiel kleinere, Toleranzbereiche gewählt und umgesetzt werden können. Zum Beispiel können isolierte Bauteile näher an die Kante der, zum Beispiel flexiblen, Leiterplatte positioniert werden. Gleichzeitig kann die Überdeckungshöhe über dem elektronischen Bauteil durch die Höhe des versteifenden Elementes leichter gewährleistet werden. Vorteilhafter Weise kann durch das gewählte versteifende Element die Materialauswahl für das Isolationsmaterial erhöht werden, d.h. es ist nicht mehr auf ein dickflüssiges Isolationsmaterial beschränkt, sondern es kann beispielsweise auch die Umgebungsluft als Isolationsmaterial genutzt werden. Ein weiterer Vorteil der erfindungsgemäßen Vorrichtung besteht darin, dass das versteifende Element gleichzeitig als ein mechanisches Befestigungselement der Platine verwendet werden kann, zum Beispiel einer flexiblen Platine, einer sogenannten FPC. Dies ermöglicht zusätzlich eine direkte Anpressung der Platine, insbesondere der flexiblen Platine, mittels einer Weichkomponente über dem vergossenen, isolierten, elektronischen Bauteil. Dies wird in einem der nachfolgenden Ausführungsbeispielen näher erläutert.

Das versteifende Element umgibt das elektronische Bauteil zumindest teilweise in der Art und Weise, dass das elektronische Bauteil trotz der (teilweisen) Isolation mittels des versteifenden Elementes mit der Platine in Verbindung kommen kann. Insbesondere umgibt das versteifen Element das elektronische Bauteil umlaufend an den Seitenflächen des elektronischen Bauteils das heißt, dass eine Oberseite und/oder ihr gegenüberliegende Unterseite von dem elektronischen Bauteil nicht umgeben, d.h. frei, von dem versteifenden Element sind. Das versteifende Element ist dabei mit einem Abstand zu dem elektronischen Bauteil angeordnet, wobei das versteifende Element in seiner Größe dem elektronischen Bauteil und dem Einsatzort, d.h. der benötigten Isolationseigenschaft angepasst wird. Dadurch wird gewährleistet, dass bei einer Herstellung der Vorrichtung das elektronische Bauteil einfach angeordnet werden kann.

In einer Ausführungsform der Erfindung kann das versteifende Element eine Ausnehmung aufweisen, in welcher das elektronische Bauteil angeordnet werden kann. Insbesondere kann die Ausnehmung das elektronische Bauteil zumindest an einer oder mehreren Seitenflächen umgeben. Die Ausnehmung kann von Oben einen Zugriff auf das elektronische Bauteil ermöglichen, sodass das elektronische Bauteil bei einer Herstellung der Vorrichtung einfach aufgebracht werden kann. Die Ausnehmung kann der Form des elektronischen Bauteils angepasst werden, d.h. die Ausnehmung kann rechteckig quadratisch oval oder rund ausgebildet werden, wobei sich nicht auf eine bestimmte Form beschränkt werden muss.

In einer Ausführungsform der Erfindung kann sich die Ausnehmung von einer ersten Seite des versteifenden Elementes bis zu einer der ersten Seite gegenüberliegenden zweiten Seite des versteifenden Elementes erstrecken. Mit anderen Worten kann sich die Ausnehmung durch das versteifende Element hindurch erstrecken, wobei die Ausnehmung das elektronische Bauteil zumindest teilweise umgibt. Die Ausnehmung kann beispielsweise eine Art Loch durch das versteifende Element sein, welches Loch sich senkrecht und/oder in einem definierten Winkel zu der Oberfläche der Leiterplatte erstreckt auf welcher das elektronische Bauteil angeordnet ist. Beispielsweise können auch abgewinkelte Seitenflächen zum Einsatz kommen, wenn ein Kegelfräser zur Herstellung der Ausnehmung verwendet wird. In anderen Worten kann sich das versteifende Element in senkrechter Richtung von der Oberfläche der Leiterplatte weg erstrecken, auf welcher das Bauteil angeordnet ist. Die Erstreckung in senkrechter Richtung ist nicht auf eine genaue senkrechte, d.h. rechtwinklige Erstreckung begrenzt, d.h. das versteifende Element kann sich auch schräg, d.h. abgewinkelt in senkrechter Richtung von der Leiterplatte weg erstrecken.

In einer Ausführungsform der Erfindung kann das versteifende Element das elektronische Bauteil zumindest an einen oder mehreren Seitenflächen des elektronischen Bauteils umgeben, welche Seitenflächen sich in senkrechter Richtung oder in einem definierten Winkel zur Oberfläche erstrecken auf welcher das elektronische Bauteil an der Leiterplatte angeordnet ist. Dadurch wird gewährleistet, dass das Bauteil oberhalb für das Isolationsmaterial zugänglich ist und das versteifende Element als Barriere für das Isolationsmaterial an den Seiten des elektronischen Bauteils dienen kann. Wenn die Ausnehmung als eine Art Loch ausgeführt ist, umgibt die Ausnehmung, und somit auch das versteifende Element, das elektronische Bauteil an dessen Seiten vollständig. Andererseits kann die Ausnehmung auch als eine seitliche Aussparung an dem versteifenden Element vorgesehen werden, sodass die Ausnehmung zu zumindest einer Seite zu einer Umgebung der Leiterplatte offen ist. Beispielsweise eine U-förmige Ausnehmung. Die Form der Ausnehmung und welche Seiten von dem elektronischen Bauteil von der Ausnehmung umgeben sind nicht auf die speziell die oben aufgeführten Ausführungsbeispiele begrenzt. Je nach Anwendungsfall kann die Ausnehmung und ihre konstruktive Form entsprechend ausgewählt werden.

In einer Ausführungsform der Erfindung kann die Leiterplatte eine mehrschichtige Leiterplatte sein. Die mehrschichtige Leiterplatte kann beispielsweise bestehen aus zumindest einer Basisschicht, einer Deckschicht und einer oder mehrerer elektrisch leitfähigen Schicht(en), wobei die eine oder mehrere elektrisch leitfähige Schicht(en) zwischen der Basisschicht und der Deckschicht angeordnet ist. Wobei die Schichten der Leiterplatte nicht auf diese oben genannte Anordnung beschränkt ist. Je nach Anforderung an die Leiterplatte und das darauf zu positionierende elektronische Bauteil, können auch noch mehr oder weniger Schichten vorgesehen werden.

In einer Ausführungsform der Erfindung kann die elektrisch leitfähige Schicht beispielsweise eine Kupferschicht sein, wobei die elektrisch leitfähige Schicht nicht auf dieses spezielle Material begrenzt ist. Das heißt es können auch andere entsprechende leitfähige Materialien für die elektrisch leitfähige Schicht verwendet werden.

In einer Ausführungsform der Erfindung kann das Bauteil auf der Deckschicht angeordnet sein und insbesondere kann das Bauteil mit der elektrisch leitfähigen Schicht durch die Deckschicht verbunden sein. Auf der anderen Seite kann das Bauteil auf der Basisschicht angeordnet sein und kann mit der elektrisch leitfähigen Schicht durch die Basisschicht verbunden werden. In der erfindungsgemäßen Vorrichtung ist die elektrisch leitfähige Schicht beispielsweise für die Kontaktierung mit dem elektronischen Bauteil vorgesehen. So kann die Deckschicht entsprechend ausgespart sein das heißt, dass diese während eines Herstellungsverfahren der Platine entsprechend freigestellt werden kann, sodass in dem Bereich in dem ein elektronisches Bauteil vorgesehen wird, die elektrisch leitfähige Schicht freilegt und für die Befestigung des elektronischen Bauteils, z.B. mittels Lötens, verfügbar und vorgesehen ist. Anderseits können sich auch andere Kontaktierungen, wie Drähte, Pins oder ähnliches von der elektrisch leitfähigen Schicht durch die Basis/Deckschicht erstrecken um die elektrisch leitfähige Schicht mit dem elektronischen Bauteil zu verbinden.

In einer Ausführungsform der Erfindung kann das elektronische Bauteil ein Sensor sein, insbesondere kann es ein Temperatursensor zur Erfassung von thermischen Quellen in der Nähe der Vorrichtung sein. Mithilfe des erfindungsgemäßen Aufbaus der Vorrichtung kann ein Sensor, welcher sehr nah am Rand einer Platine, beispielsweise einer flexiblen Platine, gelegen ist elektrisch sehr genau und mithilfe des Isolationsmaterials, beispielsweise eines Glop Top, isoliert werden. Mittels der Ausnehmung wird ein Verlaufen des Isolationsmaterials verhindert und eine undefinierte Schichtdicke oberhalb des Sensors kann vermieden werden. So kann beispielsweise ein Temperatursensor als elektronisches Bauteil in der erfindungsgemäßen Vorrichtung eine sehr hohe Dynamik der messbaren Temperatur einer externen Oberfläche gewährleisten. Dabei kann die zu messende Oberfläche ein hohes Spannungspotenzial aufweisen, dass durch die Leiterplatte, insbesondere die flexible Leiterplatte, und das versteifende Element und oder das Isolationsmaterial elektrisch vom Sensor isoliert wird und dessen Messung kaum beeinflusst.

In einer Ausführungsform der Erfindung ist die Leiterplatte eine flexible Leiterplatte. Insbesondere ist die Leiterplatte eine sogenannte FPC. Bei dickeren Leiterplatten liegen längere thermische Wege vor bis die Wärme unter der Leiterplatte zu dem elektronischen Bauteil zum Beispiel einem Temperatursensor, gelangt. D.h. bei schnellen Temperaturänderung können diese kaum erfasst werden. Das Dynamikverhalten des Temperatursensors ist somit durch die Dicke der Leiterplatte eingeschränkt. Das heißt es braucht kurze Wege um die Dynamik der Temperaturschwankungen zu verfolgen. Was mit der Verwendung einer flexible Leiterplatte gelöst werden kann, da diese in ihrem Schichtaufbau dünner ist.

In einer Ausführungsform der Erfindung kann die Vorrichtung ferner ein Kraftaufbringendes Element aufweisen, welches an dem versteifenden Element angeordnet ist und konfiguriert ist eine Kraft auf das versteifende Element aufzubringen, sodass die Vorrichtung in Richtung eines zu vermessenden Elementes gepresst werden kann. Mittels des Kraftaufbringenden Elementes kann eine mechanische Krafteinleitung ohne Einwirkung auf das elektronische Bauteil, wie einen Sensor, oder das Isolationsmaterial sehr nahe am Sensor erzeugt werden. Diese mechanische Krafteinleitung kann direkt neben den Sensor oder direkt über dem Sensor mittels des versteifenden Elementes aufgebracht werden. Dabei erfährt der Sensor keinerlei mechanische Kräfte, da die Kraft direkt auf das versteifende Element aufgebracht wird. Diese kraftfreie mechanische Anpressung eines Sensors auf eine definierte Oberfläche bei gleichzeitiger elektrischer Isolation mithilfe eines Isolationsmaterials ist ein spezifischer Zustand, welcher eine verbesserte Isolation des Sensors und gleichzeitig eine verbesserte Messgenauigkeit und verbesserte Positionsmöglichkeiten des Sensors ermöglicht. Durch das Kraftaufbringende Element kann die erfindungsgemäße Vorrichtung in Richtung eines zu vermessenden Elementes, wie eine Oberfläche oder ein anderes, externes Bauteil, gepresst werden. Das Kraftaufbringende Element kann dabei kraftschlüssig, formschlüssig oder stoffschlüssig an dem versteifenden Element angebracht, d.h. befestigt werden.

Beispielsweise kann mittels einer kraftschlüssigen Verbindung eine mechanische Kraft in das versteifende Element eingeleitet werden wodurch die Vorrichtung in Richtung eines zu vermessenden Bauteils gebracht wird dies führt beispielsweise dazu das ein Null-Spalt zu einer zu vermessenden thermischen Quelle, als zu vermessendes Element, erzeugt werden kann was bei der Verwendung eines Temperatursensors als elektronisches Bauteil dessen Messgenauigkeit erhöht.

Als Kraftaufbringende Element kann beispielsweise vorgesehen werden eine oder mehrere Schrauben, eine oder mehrere Nieten, eine oder mehrere mechanische Federn, eine oder mehrere Biegeklammern. Die hier genannten Elemente sind nur exemplarisch und es muss sich nicht darauf beschränkt werden. Es kann jedes Element, welches eine Kraft erzeugen kann, in der erfindungsgemäßen Vorrichtung Anwendung finden. Beispielsweise kann eine Verschraubung des zu versteifen Elements auf einer zu messenden Oberfläche oder an einer anderen Stelle in der Umgebung als Kraftübertragendes Element dienen. Ferner kann ein federndes Element, das sich an einem Gehäuse in welchem die Vorrichtung angeordnet ist oder an einem anderen Element in der Umgebung der Vorrichtung, abstützen und somit die Kraft auf das versteifende Element übertragen. Weiterhin ist auch die Verwendung einer Heißverstemmung ähnlich einer Vernietung des versteifenden Elements auf einer zu messenden Oberfläche möglich und/oder eine Verknüpfung mit Rasthaken oder einer ähnlichen Vorrichtung für einen mechanischen Formschluss kann als kraftaufbringendes Element verwendet werden.

In einer Ausführungsform der Erfindung kann die Kraft durch das kraftaufbringende Element senkrecht auf das zu versteifen Element aufgebracht werden. In anderen Worten kann die aufzubringende Kraft zumindest immer eine senkrechte Komponente aufweisen, welche auf das zu versteifen Element ausgerichtet ist. Dadurch kann eine genaue Position des elektronischen Bauteils gegenüber dem zu vermessenden Element gewährleistet werden.

In einer Ausführungsform der Erfindung kann das elektronische Bauteil mit einem geringen Abstand zu einem Rand der Leiterplatte angeordnet sein, wobei der Abstand insbesondere in einem Bereich von 0,5 mm bis 30 mm liegt, mehr insbesondere in einem Bereich von 0,5 mm bis 10 mm. Durch die erfindungsgemäße Vorrichtung und die Anordnung der Leiterplatte und des versteifenden Elementes und des elektronischen Bauteils zueinander kann das elektronische Bauteil somit näher an einen Rand der Leiterplatte angeordnet werden. Dadurch ergibt sich bei beispielsweise eine bessere Zugänglichkeit für das elektronische Bauteil und auch eine Materialersparnis da die Leiterplatte verkleinert werden könnte. Der Abstand des elektronischen Bauteils zum Rand der Leiterplatte ist dabei, beispielsweise abhängig von der Isolation des elektronischen Bauteils und/oder von der Herstellungsweise des versteifen Elementes.

In einer Ausführungsform der Erfindung kann das versteifende Element ferner ein Isolationsmaterial aufweisen, welches konfiguriert und angeordnet ist das elektronische Bauteil von der Umgebung zu isolieren. Dieses zusätzliche Isolationsmaterial kann die Isolationseigenschaft der erfindungsgemäßen Vorrichtung weiter erhöhen.

In einer Ausführungsform der Erfindung kann das Isolationsmaterial das elektronische Bauteil zumindest teilweise umgeben. Dadurch wird das elektronische Bauteil entsprechend von der äußeren Umgebung isoliert. Insbesondere umgibt das Isolationsmaterial das elektronische Bauteil seitlich und von oben. D.h., dass das elektronische Bauteil zumindest an der Seite, mit welcher es mit der Leiterplatte in Kontakt kommt bzw. mit der Seite mit welcher es an der Oberfläche der Platine angeordnet ist, frei von Isolationsmaterial bleibt.

In einer Ausführungsform der Erfindung kann das Isolationsmaterial in der Ausnehmung angeordnet werden, und kann die Ausnehmung zumindest teilweise ausfüllen. In anderen Worten ist kann die Ausnehmung vollständig und oder nur teilweise von dem Isolationsmaterial ausgefüllt werden. Das heißt dass das elektronische Bauteil teilweise und oder vollständig von dem Isolationsmaterial umgeben und damit von diesen bedeckt werden kann.

In einer Ausführungsform der Erfindung kann das Isolationsmaterial ein flüssiges Isolationsmaterial und/oder ein dickflüssiges Isolationsmaterial ist und/oder ein aushärtendes Isolationsmaterial sein. Vorteilhafter Weise, ist man durch die Verwendung des versteifenden Elements, welches als Barriere für das Isolationsmaterial dienen kann nicht auf ein bestimmtes Isolationsmaterial beschränkt. Durch das versteifende Element kann die Materialauswahl für das Isolationsmaterial erhöht werden, sondern es kann Isolationsmaterial mit anderen Fluideigenschaften verwendet werden. Ferner kann bei der Verwendung von flüssigen Material das Verlaufen durch das versteifende Element verhindert werden. Ferner kann bei der Verwendung von flüssigen Isolationsmaterial im Vergleich zum dickflüssigen Isolationsmaterial die Neigung zum Blasenbilden im Isolationsmaterial verringert werden, was wiederum Teilentladungen innerhalb der Blasen vermindert und die Isolationsfähigkeit über die Lebenszeit erhöht. Mit der vorliegenden Vorrichtung kann nunmehr auch auf dünnflüssiges Isolationsmaterial zurückgegriffen und somit die Isolationseigenschaften erheblich verbessert werden. Somit werden insgesamt die Isolationseigenschaften der erfindungsgemäßen Vorrichtung verbessert.

Gleichzeitig kann die Überdeckungshöhe des Isolationsmaterials über dem elektronischen Bauteil durch die Höhe des versteifenden Elementes in Zusammenspiel mit der Ausnehmung leichter gewährleistet werden. Durch die verbesserte Aufbringung und Positionierung des Isolationsmaterials über dem elektronischen Bauteil kann gewährleistet werden, dass die Höhe des Isolationsmaterials über dem elektronischen Bauteil gleichbleibend ist und ein Verlaufen und somit damit einhergehende verschiedene Schichtdicken des Isolationsmaterials verringert wird. Dies verbessert ebenfalls die Isolationseigenschaften der erfindungsgemäßen Vorrichtung im Hinblick auf die Gefahr von Hochspannung und Überschlägen auf der Platine.

In einer Ausführungsform der Erfindung kann das Isolationsmaterial die Ausnehmung des versteifenden Elements komplett ausfüllen und/oder das Bauteil wird seitlich und oberhalb des elektronischen Bauteils vollständig von dem Isolationsmaterial umgeben. Zum Beispiel umgibt das Isolationsmaterial das elektronische Bauteil auf einer Oberseite und, wenn es sich beispielsweise um ein rechteckiges elektronisches Bauteil handelt, an allen vier Seitenflächen des elektronischen Bauteils, sodass lediglich die Unterseite des elektrischen Bauteils frei bleibt und das elektronische Bauteil an dieser Unterseite mit der Platine, insbesondere mit der elektrisch leitfähigen Schicht, in Kontakt kommen kann. Beispielsweise kann das Isolationsmaterial auch ein so genannter Glop Top sein.

Gemäß einem Aspekt der Erfindung kann die Vorrichtung gemäß einem der beschriebenen Ausführungsbeispiele zum Isolieren eines elektronischen Bauteils in einem Ladepfad von einem elektrisch betriebenen Fahrzeug verwendet werden. Insbesondere kann die Vorrichtung in einer Ladedose verwendet werden wobei es sich bei der Ladedose um die Schnittstelle eines elektrischen Fahrzeugs zu beispielsweise einer externen Ladesäule oder auch einer Steckdose handeln kann. Insbesondere kann die Vorrichtung in einem Ladepfad von einer Ladeinfrastruktur zu einem elektrischen Energiespeicher in einem elektrisch betriebenen Fahrzeug angewandt, eingesetzt werden.

Gemäß einem Aspekt der Erfindung kann beispielsweise die erfindungsgemäße Vorrichtung in einer Ladedose angeordnet werden. Gemäß dieser beispielhaften Anwendung werden Temperatursensoren auf einer flexiblen Leiterplatte auf den Pintellern von Ladedosenpins mithilfe des versteifenden Elementes nieder gepresst. Dadurch ist der thermische Pfad von Pinteller zum Temperatursensor gewährleistet. Das Hochspannungspotenzial der Ladepins wird durch die flexible Leiterplatte und das Isolationsmaterial effektiv von dem Temperatursensor isoliert. Durch die ausreichend gestaltete Fläche des versteifenden Elements kann die mechanische Anpassung sehr einfach erfolgen. In diesem Beispiel kann die mechanische Anpressung durch eine Verschraubung im Innenteil mit einem Stück Gehäuse der Ladedose erzeugt werden.

Gemäß einem weiteren Aspekt der Erfindung wird ein Verfahren zur Isolierung eines elektronischen Bauteils auf einer Leiterplatte bereitgestellt, wobei das Verfahren die Schritte aufweist: Bereitstellen einer Leiterplatte; Aufbringen eines versteifenden Elementes auf einer Oberfläche der Leiterplatte, welches das elektronische Bauteil zumindest teilweise umgibt; Anordnen eines elektronischen Bauteils auf der Oberfläche der Leiterplatte, wobei das versteifende Element das elektronische Bauteil von der Umgebung isoliert.

Weitere mögliche Verfahrensschritte, um welche das Verfahren ergänzt werden kann sind beispielsweise ein Einbringen bzw. Erzeugen einer Ausnehmung in dem versteifenden Element, ein bereitstellen eines Kraftaufbringenden Elementes, welches an dem versteifenden Element angeordnet wird, Bereitstellen einer leitfähigen Kontaktierung zwischen der Leiterplatte und dem elektronischen Bauteil. Anzumerken ist, dass das Verfahren um entsprechende Verfahrensschritte, ähnlich der oben beschriebenen Ausführungsformen betreffend die Vorrichtung ergänzt werden kann.

Weiterhin soll darauf hingewiesen werden, dass alle ein Verfahren betreffende Ausführungsformen der vorliegenden Erfindung in der beschriebenen Reihenfolge der Schritte ausgeführt werden können. Trotzdem muss das nicht die einzigmögliche und erforderliche Reihenfolge der Schritte des Verfahrens sein. Die hierin beschriebenen Verfahren können in einer anderen Reihenfolge der offenbarten Schritte ausgeführt werden, ohne von der entsprechenden Ausführungsform des Verfahrens abzuweichen, sofern nicht nachfolgend ausdrücklich das Gegenteil erwähnt wird.

Die Leiterplatte welche in der erfindungsgemäßen Vorrichtung und dem erfindungsgemäßen Verfahren verwendet wird kann eine vorgefertigte Leiterplatte, insbesondere eine flexible Leiterplatte sein. Insbesondere kann das Verfahren noch vorgelagerte Schritte aufweisen, welche das bestücken der flexible Leiterplatte umfasst bis die gewünschte flexible Leiterplatte gefertigt wurde. Anschließend können die oben beschriebenen Verfahrensschritte erfolgen.

Als elektronisches Bauteil wird vorliegend jedes beliebige Bauteil, welches auf einer Platine angebracht werden kann verstanden. Insbesondere sind solche elektronischen Bauteile gemeint, mit welchen die Eigenschaften der Umgebung und oder der Platine und oder der Bauteile selbst oder von anderen Bauteilen gemessen werden können. Nicht abschließende Beispiele hierfür sind insbesondere Temperatursensoren, Dehnungsmessstreifen, Piezoelemente und Heizflächen.

Anzumerken ist, dass bei der erfindungsgemäßen Vorrichtung auch mehr als ein elektronisches Bauteil verwendet werden kann. Dementsprechend wird das versteifende Element in seiner Form und Ausgestaltung angepasst, sodass beispielsweise je nach Bauteilanzahl die entsprechende Anzahl von Ausnehmungen und Isolationsmaterial in dem versteifenden Element vorgesehen wird, wobei sich die Anzahl der Bauteile und die Anzahl der Ausnehmungen sich nach der gewählten Ausführungsform richtet.

Weitere Merkmale, Vorteile und Anwendungsmöglichkeiten der Erfindung ergeben sich aus der nachfolgenden Beschreibung von vorteilhaften Ausführungsformen und den begleitenden Figuren.

### Kurze Figurenbeschreibung

Nachfolgend wird ein vorteilhaftes Ausführungsbeispiel der Erfindung unter Bezugnahme auf die begleitenden Figuren erläutert. Es zeigen:
Figur 1 zeigt eine schematische Darstellung einer Vorrichtung gemäß einer Ausführungsform der Erfindung.
Figur 2 zeigt eine schematische Darstellung einer Schnittansicht einer exemplarischen Vorrichtung gemäß einer Ausführungsform der Erfindung.
Figur 3 zeigt eine schematische Darstellung einer vergrößerten Schnittansicht der exemplarischen Vorrichtung aus Figur 2.

Die Figuren sind lediglich schematische Darstellungen und dienen nur der Erläuterung der Erfindung. Gleiche oder gleichwirkende Elemente sind durchgängig mit den gleichen Bezugszeichen versehen.

### Detaillierte Beschreibung

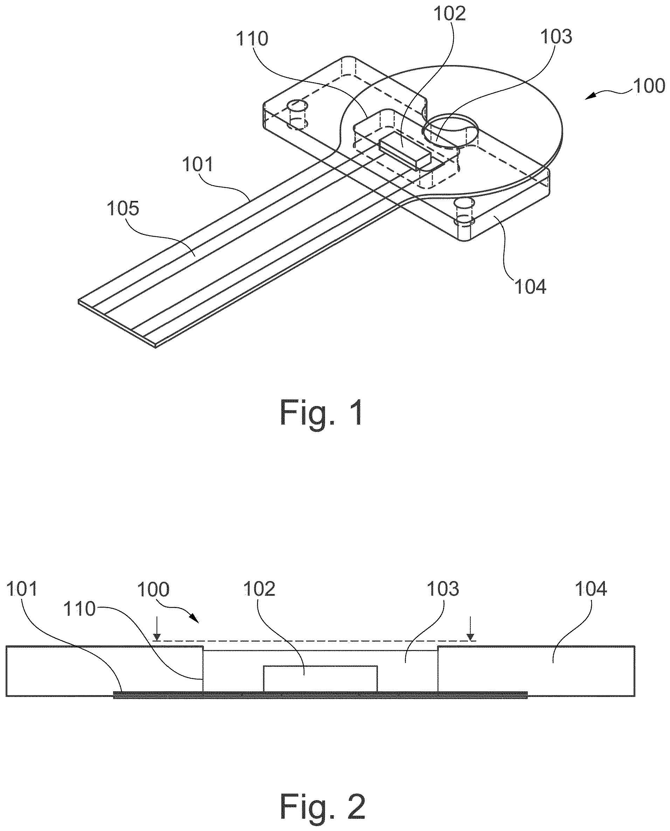

Fig. 1 zeigt in eine schematische Darstellung einer Schnittansicht einer exemplarischen Vorrichtung 100 gemäß einer Ausführungsform der Erfindung. Die Vorrichtung 100 zur Isolierung eines elektronischen Bauteils 102, weist auf: eine Leiterplatte 101, ein elektronisches Bauteil 102 angeordnet auf einer Oberfläche der Leiterplatte 101, ein versteifendes Element 104, welches konfiguriert und angeordnet ist das elektronische Bauteil 102 zumindest teilweise zu umgeben, wobei das versteifende Element 104 an der Oberfläche der Leiterplatte 101 angeordnet ist. Ferner weist die Vorrichtung 100 ein Isolationsmaterial 103 auf, welches konfiguriert und angeordnet ist das elektronische Bauteil 102 von der Umgebung zu isolieren. Dieses Isolationsmaterial 103 kann auch weggelassen werden, sodass allein das versteifende Element 104 zum Isolieren, als Isolation für, des elektronischen Bauteils 102 dient. Wie aus der Fig. 1 zu entnehmen ist, ist das elektronische Bauteil 102 innerhalb der Ausnehmung 110 angeordnet und wird von dem zu versteifenden Element 104 an zumindest den Seitenflächen umgeben, welche sich senkrecht zu der Oberfläche an welcher das elektronische Bauteil 102 an der Leiterplatte 101 angebracht ist erstreckt. D.h. das elektronische Bauteil 102 ist von oben zugänglich. Insbesondere kann von oben auf das elektronische Bauteil 102 das Isolationsmaterial 103 aufgebracht werden, sodass sich auch das Isolationsmaterial 103 innerhalb der Ausnehmung 110 des zu versteifenden Elementes 104 befindet. Das elektronische Bauteil ist mit der elektrisch leitfähigen Schicht 105 in Kontakt. Gemäß dieser Ausführungsform sind zwei in einer Ebene nebeneinander parallel angeordnete elektrisch leitfähige Schichten 105 angeordnet um entsprechende Leiterbahnen zu dem elektronischen Bauteil 102 auszubilden. Bei dem elektronischen Bauteil 102 handelt es sich beispielsweise um einen rechteckigen Temperatursensor, wobei die Ausnehmung 110 in ihrer Form an den Temperatursensor 102 angepasst ist. Das Isolationsmaterial 103 füllt die Ausnehmung 110 fast vollständig aus, insbesondere in der Art das eine Oberfläche des Isolationsmaterials 103 welche der Oberfläche der Leiterplatte 101 gegenüberliegt sich auf derselben Ebene wie die Oberfläche des versteifenden Elements 104 befindet. In der hier dargestellten schematischen Ausführungsform umgibt die Ausnehmung 110 und somit auch das versteifende Element 104 das elektronische Bauteil 102 von vier Seiten. D.h. die Oberseite und die Unterseite des elektronischen Bauteils 102 sind ausgespart und werden nicht von der Ausnehmung 110, dem versteifenden Element 104, umgeben.

Fig. 2 zeigt eine schematische Darstellung einer Schnittansicht einer exemplarischen Vorrichtung gemäß einer Ausführungsform der Erfindung. In dieser Figur ist erkennbar, dass das Isolationsmaterial 103 nicht vollständig bis zum oberen Rand des versteifenden Elements 104 eingebracht ist, das heißt, dass es die Ausnehmung 110 nur teilweise ausfüllt. Jedoch bedeckt das Isolationsmaterial 103 das elektronische Bauteil 102 von der Oberseite und von den Seitenflächen senkrecht zur Oberseite der Leiterplatte 101. Mit der gestrichelten Linie ist in der Fig. 2 die aufzubringende Kraft dargestellt, welche mittels der hierin beschriebenen Ausführungsformen betreffend das Krafteinbringende Element erzeugt werden kann. Beispielsweise kann eine Schraube an dem versteifende Element 104 eingeschraubt werden, wobei die Schraube nahe an der Ausnehmung 110 positioniert werden kann.

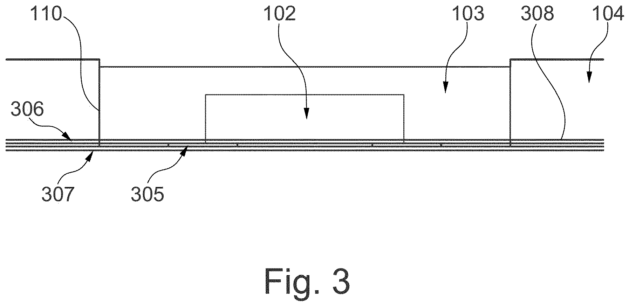

Fig. 3 zeigt eine schematische Darstellung einer vergrößerten Schnittansicht der exemplarischen Vorrichtung aus Figur 2. Insbesondere ist Fig. 3 derart vergrößert, dass die einzelnen Schichten der Leiterplatte 101 erkennbar sind. In diesem Ausführungsbeispiel handelt es sich somit um eine mehrschichtige Leiterplatte 101, welche aus zumindest drei Schichten besteht. Diese drei Schichten sind die Basisschicht 307, die Deckschicht 306, und die zwischen diesen beiden Schichten liegende elektrisch leitfähige Schicht 305. Je nach gewählter Ausführungsform kann die Leiterplatte 101 auch mehr als drei Schichten umfassen und die Anordnung der elektrisch leitfähigen Schicht 305 kann sich von der dargestellten Anordnung unterscheiden.

Obwohl die Erfindung in den Zeichnungen und der vorstehenden Beschreibung illustriert und detailliert beschrieben wurde, sind diese Zeichnungen und Beschreibungen als illustrativ oder beispielhaft zu verstehen und nicht als einschränkend zu betrachten. Die Erfindung ist nicht auf die offenbarten Ausführungsformen beschränkt. Andere Variationen der offenbarten Ausführungsformen können von den Fachleuten, die die beanspruchte Erfindung ausführen, anhand der Zeichnungen, der Offenbarung und der abhängigen Ansprüche verstanden und ausgeführt werden.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

### BEZUGSZEICHENLISTE

- 100: Vorrichtung
- 101: Leiterplatte
- 102: elektronisches Bauteil
- 103: Isolationsmaterial
- 104: versteifendes Element
- 105: elektrisch leitfähige Schicht
- 110: Ausnehmung
- 306: Deckschicht
- 307: Basisschicht
- 308: Oberfläche der Deckschicht

## Patentansprüche

1. Vorrichtung zum Isolieren eines elektronischen Bauteils, aufweisend:
eine Leiterplatte,
ein elektronisches Bauteil angeordnet auf einer Oberfläche der Leiterplatte,
ein versteifendes Element, welches konfiguriert und angeordnet ist das elektronische Bauteil zumindest teilweise zu umgeben, wobei das versteifende Element an der Oberfläche der Leiterplatte angeordnet ist,
wobei das versteifende Element konfiguriert und angeordnet ist das elektronische Bauteil von einer Umgebung zu isolieren.

2. Vorrichtung gemäß Anspruch 1,
wobei das versteifende Element eine Ausnehmung aufweist, in welcher das elektronische Bauteil angeordnet ist,
wobei sich die Ausnehmung von einer ersten Seite des versteifenden Elementes bis zu einer der ersten Seite gegenüberliegenden zweiten Seite des versteifenden Elementes erstreckt.

3. Vorrichtung gemäß einem der vorhergehenden Ansprüche 1 bis 2,
wobei das versteifende Element das elektronische Bauteil zumindest an einen oder mehreren Seitenflächen des elektronischen Bauteils umgibt, welche Seitenflächen sich in senkrechter Richtung oder in einem definierten Winkel zur Oberfläche erstrecken auf welcher das elektronische Bauteil an der Leiterplatte angeordnet ist.

4. Vorrichtung gemäß einem der vorhergehenden Ansprüche 1 bis 3,
wobei die Leiterplatte eine mehrschichtige Leiterplatte ist, bestehend aus zumindest einer Basisschicht, einer Deckschicht und einer oder mehrerer elektrisch leitfähigen Schicht, wobei die eine oder mehrere elektrisch leitfähige Schicht zwischen der Basisschicht und der Deckschicht angeordnet ist.

5. Vorrichtung gemäß Anspruch 4,
wobei das Bauteil auf der Deckschicht angeordnet ist und wobei das Bauteil mit der elektrisch leitfähigen Schicht durch die Deckschicht verbunden ist, oder
wobei das Bauteil auf der Basisschicht angeordnet ist und wobei das Bauteil mit der elektrisch leitfähigen Schicht durch die Basisschicht verbunden ist.

6. Vorrichtung gemäß einem der vorhergehenden Ansprüche,
wobei das elektronische Bauteil ein Sensor ist, insbesondere ein Temperatursensor und/oder,
wobei die Leiterplatte eine flexible Leiterplatte ist.

7. Vorrichtung gemäß einem der vorhergehenden Ansprüche, ferner aufweisend
ein Kraftaufbringendes Element, welches an dem versteifenden Element angeordnet ist und konfiguriert ist eine Kraft auf das versteifende Element aufzubringen, sodass die Vorrichtung in Richtung eines zu vermessenden Elementes gepresst werden kann.

8. Vorrichtung gemäß einem der vorhergehenden Ansprüche,
wobei das elektronische Bauteil mit einem geringen Abstand zu einem Rand der Leiterplatte angeordnet ist, wobei der Abstand insbesondere in einem Bereich von 0,5 mm bis 30 mm liegt, mehr insbesondere in einem Bereich von 0,5 mm bis 10 mm.

9. Vorrichtung gemäß einem der vorhergehenden Ansprüche,
wobei das versteifende Element ferner ein Isolationsmaterial aufweist, welches konfiguriert und angeordnet ist das elektronische Bauteil von der Umgebung zu isolieren,
wobei das Isolationsmaterial das elektronische Bauteil insbesondere seitlich und von oben umgibt.

10. Vorrichtung gemäß einem der Ansprüche 2 bis 9,
wobei das Isolationsmaterial in der Ausnehmung des versteifenden Elementes angeordnet ist und die Ausnehmung zumindest teilweise ausfüllt.

11. Verwendung einer Vorrichtung zum Isolieren eines elektronischen Bauteils gemäß einem der Ansprüche 1 bis 11, in einem Ladepfad von einem elektrisch betriebenen Fahrzeug.

12. Verfahren zum Isolieren eines elektronischen Bauteils auf einer Leiterplatte, wobei das Verfahren die Schritte aufweist:
Bereitstellen einer Leiterplatte;
Aufbringen eines versteifenden Elementes auf eine Oberfläche der Leiterplatte, welche das elektronische Bauteil zumindest teilweise umgibt;
Anordnen eines elektronischen Bauteils auf der Oberfläche der Leiterplatte;
wobei das versteifende Element das elektronische Bauteil von einer Umgebung isoliert.
